# FASCICULE DE BREVET EUROPEEN

(11) **EP 2 773 052 B1**
(45) Date de publication et mention de la délivrance du brevet: **29.07.2015**
(21) Numéro de dépôt: 13305229.0
(22) Date de dépôt: 28.02.2013
(51) Int. Cl.: H04B 10/40, G02B 6/42, H01S 5/10

(54) **Emetteur-recepteur optique**
Optischer Sender-Empfänger
Optical transceiver

(43) Date de publication de la demande: 03.09.2014
(73) Titulaire: ALCATEL LUCENT, 92100 Boulogne-Billancourt (FR); COMMISSARIAT A L'ENERGIE ATOMIQUE ET AUX ENERGIES ALTERNATIVES, 75015 Paris (FR)
(72) Inventeur: Brenot, Romain, 91767 Palaiseau (FR); Chimot, Nicolas, 91460 Marcoussis (FR)
(74) Mandataire: Loyer & Abello

(56) Documents cités:
- EP-A2- 1 699 118
- WO-A1-2010/107350
- US-A1- 2008 240 725
- US-A1- 2009 285 251
- US-A1- 2010 021 171

## Description

### Domaine technique

L'invention se rapporte au domaine des communications optiques, et plus particulièrement à des dispositifs émetteurs-récepteurs optiques pouvant être utilisées pour émettre et recevoir des signaux optiques de communication modulés.

### Arrière-plan technologique

La maîtrise de la technologie de la transmission par fibre optique à multiplexage de longueurs d'onde optique (WDM pour l'anglais "Wavelength Division Multiplexing") est un facteur important pour répondre aux besoins croissants de débits dans la transmission d'informations. Le multiplexage en longueur d'onde, appelé WDM par la suite, consiste à combiner sur une même fibre plusieurs signaux modulés portés chacun par un canal de longueur d'onde différent. Ainsi, le débit global d'une ligne de transmission est égal à la somme des débits des différents signaux. Toutefois, le WDM impose de contrôler précisément les longueurs d'ondes utilisées, tant à l'émission qu'à la réception. Une émission sur un canal de longueur d'onde mal contrôlé peut en effet créer une interférence avec un autre signal présent sur la ligne, et donc une dégradation des deux signaux, également appelée collision spectrale. La réception d'un signal sur un canal de longueur d'onde mal contrôlé par un récepteur peut avoir pour effet de diminuer la qualité de la réception ou de détecter un autre signal que celui qui était réellement destiné au récepteur. Des émetteurs et récepteurs optiques ayant une longueur d'onde de fonctionnement fixe ou accordable peuvent être utilisés dans les réseaux WDM.

Le document de brevet WO2010/107350 A1 décrit un émetteur-récepteur optique comprenant un anneau résonateur avec un seul port d'entrée et sortie de données.

### Résumé

Une idée à la base de l'invention est de fournir un émetteur-récepteur optique dont une longueur d'onde d'émission et une longueur d'onde de réception présentent un écart bien contrôlé.

Selon un mode de réalisation, l'invention fournit un émetteur-récepteur optique comportant :
un anneau résonateur,
un premier guide d'onde comprenant successivement une section d'entrée-sortie,
une section de couplage couplée à une première portion de l'anneau résonateur et une section d'amplification couplée à un premier réflecteur optique, le premier réflecteur optique étant apte à réfléchir de la lumière en direction de la section de couplage,
un deuxième guide d'onde comportant successivement une section de réception, une section de couplage couplée à une deuxième portion de l'anneau résonateur et une section de réflexion couplée à un deuxième réflecteur optique, le deuxième réflecteur optique étant apte à réfléchir de la lumière en direction de la section de couplage,
un milieu à gain agencé dans la section d'amplification du premier guide d'onde et apte à produire une émission stimulée de lumière, et
un détecteur optique couplé à la section de réception du deuxième guide d'onde.

Grâce à ces caractéristiques, l'anneau résonateur réalise un couplage entre la section d'amplification et la section de réflexion. Une cavité laser est ainsi réalisée entre les deux réflecteurs optiques, par l'intermédiaire de la section d'amplification, la première section de couplage, l'anneau résonateur, la deuxième section de couplage et la section de réflexion. Le signal laser généré lorsque le milieu à gain est activé, c'est-à-dire alimenté en énergie, par exemple par une tension électrique, peut sortir vers l'extérieur à travers la section d'entrée-sortie du premier guide d'onde. Les modes résonnants de Fabry-Pérot de cette cavité laser dépendent des caractéristiques de l'anneau résonateur. En changeant les caractéristiques de l'anneau résonateur, par exemple son indice de réfraction, il est possible de changer la ou les longueurs d'onde optique de résonance, et donc de réaliser une source accordable en longueur d'onde.

Grâce à ces caractéristiques, l'anneau résonateur réalise aussi un couplage entre la section d'entrée-sortie et la section de réception, de sorte qu'il est possible de détecter avec le détecteur optique un signal optique reçu à travers la section d'entrée-sortie depuis une source extérieure. L'anneau résonateur agit dans les deux cas comme un filtre fréquentiel périodique, qui laisse passer plusieurs bandes de fréquences optiques relativement étroites espacées d'un intervalle fixe appelé l'intervalle spectral libre de l'anneau résonateur. Cet intervalle qui dépend de la conception et de la géométrie de l'anneau résonateur peut être contrôlé avec une précision élevée. Il est aussi possible de régler la position absolue de ces bandes de fréquences optiques en changeant les caractéristiques de l'anneau résonateur, par exemple son indice de réfraction, de manière à réaliser un récepteur accordable en longueur d'onde.

Il est ainsi possible d'obtenir un émetteur récepteur optique apte à émettre un rayonnement laser sur une première longueur d'onde résonante et à détecter un signal optique reçu sur une deuxième longueur d'onde résonante, dans lequel l'écart entre la première longueur d'onde résonante et la deuxième longueur d'onde résonante et égal à un ou un multiple entier de l'intervalle spectral libre de l'anneau résonateur. De ce fait, cet écart peut être précisément contrôlé à travers une réalisation également précise et contrôlée de l'anneau résonateur.

Selon des modes de réalisation, un tel émetteur-récepteur optique peut comporter une ou plusieurs des caractéristiques suivantes.

Selon un mode de réalisation, l'émetteur-récepteur comporte en outre un mécanisme de réglage de la longueur d'onde apte à modifier une propriété physique de l'anneau résonateur pour régler la ou les fréquences de résonance de l'anneau résonateur. Pour cela, des propriétés telles que la longueur optique ou l'indice de réfraction de l'anneau résonateur peuvent être modifiées de cette manière. Selon un mode de réalisation, le mécanisme de réglage de la longueur d'onde est apte à injecter un courant électrique dans l'anneau résonateur. Selon un autre mode de réalisation, le mécanisme de réglage de la longueur d'onde est apte à modifier la température de l'anneau résonateur pour changer l'indice de réfraction de l'anneau résonateur par effet thermo-optique. Selon un mode de réalisation, l'émetteur-récepteur optique comporte un film chauffant déposé sur l'anneau résonateur.

Grâce à ces caractéristiques, étant donné que l'intervalle spectral libre de l'anneau résonateur peut être conservé essentiellement fixe à travers les modifications de température, il est possible de régler simultanément une première longueur d'onde résonante exploitée pour l'émission d'un signal optique et une deuxième longueur d'onde résonante exploitée pour la réception d'un signal optique par l'émetteur-récepteur, sans changer l'écart entre ces deux longueurs d'onde résonantes. Il est ainsi possible de mettre en oeuvre des procédés d'accordage en longueur d'onde relativement économiques, en réglant explicitement l'une des deux longueurs d'onde résonante, ce qui produit un réglage implicite de l'autre longueur d'onde résonante sans qu'une détection effective de cette l'autre longueur d'onde résonante ne soit mise en oeuvre.

Par exemple, une opération d'accordage de la longueur d'onde résonante reçue par le détecteur, dans laquelle on détecte effectivement le signal optique au niveau du détecteur, produit intrinsèquement un accordage correspondant de la longueur d'onde résonante émise par la cavité laser, et cela sans qu'il ne soit nécessaire de détecter ou d'analyser un signal optique émis par la cavité laser de l'émetteur-récepteur. Ceci résulte du fait qu'on peut connaître précisément et sans difficulté l'intervalle spectral libre de l'anneau résonateur qui régit l'écart fixe entre ces deux longueurs d'onde résonantes.

Des paramètres tels que le matériau et la géométrie de l'anneau résonateur permettent de régler l'intervalle spectral libre de l'anneau résonateur lors de sa conception.

Du fait du spectre périodique de l'anneau résonateur, il peut arriver, du moins en théorie, que la cavité laser émette simultanément des signaux optiques amplifiés sur plusieurs longueurs d'ondes résonantes. Pour éviter cela et obtenir en particulier une longueur d'onde d'émission unique et bien contrôlée, des caractéristiques du milieu à gain et de l'anneau résonateur, notamment sa finesse, peuvent être soigneusement choisies. Selon un mode de réalisation correspondant, la géométrie est telle que la largeur spectrale d'un mode résonant de l'anneau résonateur est inférieure à l'intervalle spectral libre de la cavité laser.

La largeur spectrale du milieu à gain influence aussi la sélection de mode par la cavité laser. Des paramètres tels que le matériau et la géométrie du milieu à gain permettent de régler la largeur spectrale du milieu à gain lors de sa conception. De préférence, pour qu'un mode unique soit amplifié, la largeur spectrale du milieu à gain est inférieure à l'intervalle spectral libre de l'anneau résonateur.

Selon un mode de réalisation, le milieu à gain comporte un matériau à puits quantique.

Selon un mode de réalisation, l'émetteur-récepteur optique comporte en outre un substrat sur lequel l'anneau résonateur, le premier guide d'onde et le deuxième guide d'onde sont intégrés de manière monolithique. Selon un mode de réalisation, le substrat est en Silicium ou en matériau InP.

Selon un mode de réalisation, l'émetteur-récepteur optique comporte en outre un film réfléchissant déposé sur une surface d'extrémité du substrat et formant les premier et deuxième réflecteurs optiques.

Selon un mode de réalisation, l'émetteur-récepteur optique comporte en outre un modulateur optique couplé au premier guide d'onde pour moduler un signal optique généré par le milieu à gain. Un tel modulateur optique peut être réalisée de manière intégrée avec le milieu à gain en effectuant directement un contrôle de gain correspondant aux données à transmettre, ou de manière externe au milieu à gain, par exemple sous la forme d'un modulateur à électro-absorption disposé dans le premier guide d'onde.

Selon un mode de réalisation, l'émetteur-récepteur optique comporte en outre une unité de commande apte à piloter le gain du milieu à gain, par exemple en réglant un courant de pompage, et/ou d'autres éléments de l'émetteur-récepteur optique, tels que le détecteur optique, le mécanisme de réglage de la longueur d'onde, le modulateur optique et autres.

Selon un mode de réalisation, l'émetteur-récepteur optique comporte en outre un filtre spectral agencé dans la section de réception en amont du détecteur optique pour laisser passer un signal optique à recevoir par le détecteur optique et bloquer un signal optique à émettre par l'émetteur-récepteur. Selon un mode de réalisation, le filtre spectral est un filtre passe-bas, la longueur d'onde du signal à recevoir étant plus grande que la longueur d'onde du signal à émettre.

Selon un mode de réalisation, l'invention fournit aussi un procédé d'exploitation d'un émetteur-récepteur optique susmentionné, dans lequel
dans un mode de fonctionnement émetteur dans lequel le milieu à gain est activé, l'émetteur récepteur optique transmet vers l'extérieur à travers la section d'entrée-sortie un signal optique monochromatique ayant une première longueur d'onde porteuse, et
dans un mode de fonctionnement récepteur, dans lequel le milieu à gain peut être désactivé, l'émetteur récepteur optique reçoit depuis l'extérieur à travers la section d'entrée-sortie un signal optique comportant une composante monochromatique ayant une deuxième longueur d'onde porteuse, l'écart entre la première longueur d'onde porteuse et la deuxième longueur d'onde porteuse étant égal à l'intervalle spectral libre de l'anneau résonateur ou un multiple entier de celui-ci.

Selon un mode de réalisation, la section d'entrée-sortie de l'émetteur-récepteur optique est reliée par un réseau optique à un noeud de communication, dans lequel le signal optique monochromatique ayant la première longueur d'onde porteuse est modulé avec un flux de données montant et transporte le flux de données montant depuis l'émetteur-récepteur optique jusqu'au noeud de communication, et
dans lequel la composante monochromatique ayant la deuxième longueur d'onde porteuse est modulée avec un flux de données descendant et transporte le flux de données descendant depuis le noeud de communication jusqu'à l'émetteur-récepteur optique.

Selon un mode de réalisation, le mode de fonctionnement émetteur et le mode de fonctionnement récepteur sont exploités alternativement selon un schéma périodique de duplexage temporel. Selon un autre mode de réalisation, le mode de fonctionnement émetteur et le mode de fonctionnement récepteur sont exploités simultanément selon un schéma de duplexage spectral.

Certains aspects de l'invention partent de l'idée de coupler un filtre optique résonant à la fois à une source et à un détecteur optique de manière à caler la longueur d'onde de fonctionnement de la source et du récepteur en fonction de l'intervalle spectral libre du résonateur optique.

Certains aspects de l'invention partent de l'idée de réaliser un filtre optique permettant de régler simultanément une longueur d'onde porteuse d'émission et une longueur d'onde porteuse de réception présentant un écart prédéterminé l'une avec l'autre. Certains aspects de l'invention partent de l'idée de réaliser de manière intégrée la source, le détecteur et ce filtre optique.

### Brève description des figures

L'invention sera mieux comprise, et d'autres buts, détails, caractéristiques et avantages de celle-ci apparaîtront plus clairement au cours de la description suivante de plusieurs modes de réalisation particuliers de l'invention, donnés uniquement à titre illustratif et non limitatif, en référence aux dessins annexés.
- La figure 1 est une représentation schématique fonctionnelle d'un émetteur-récepteur optique intégré selon un mode de réalisation.
- La figure 2 est une représentation analogue à la figure 1 montrant également des moyens de commande de l'émetteur-récepteur optique selon un mode de réalisation.
- La figure 3 est une représentation graphique des longueurs d'onde porteuses pouvant être émises et reçues par l'émetteur-récepteur optique de la figure 2.
- La figure 4 est une représentation schématique fonctionnelle d'un réseau d'accès dans lequel l'émetteur-récepteur optique peut être utilisé.
- La figure 5 est une représentation schématique fonctionnelle d'un émetteur-récepteur optique intégré selon un autre mode de réalisation.
- La figure 6 est une représentation graphique des longueurs d'onde porteuses pouvant être émises et reçues par l'émetteur-récepteur optique de la figure 5.

### Description détaillée de modes de réalisation

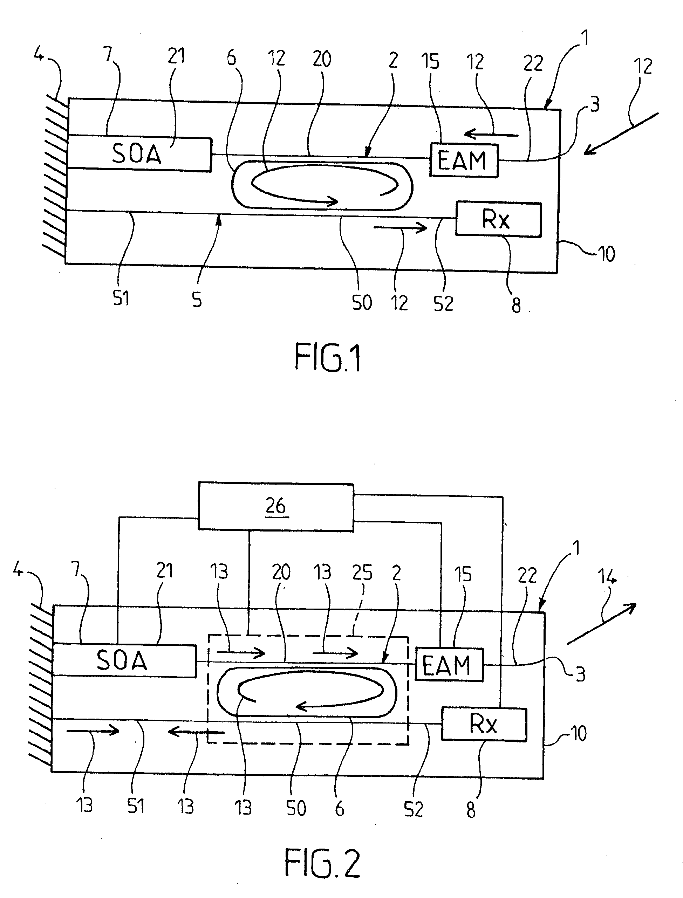

En référence à la figure 1, on a représenté un émetteur récepteur optique 1 fabriqué de manière intégrée sur un substrat 10. Un premier guide d'onde 2 s'étend de manière rectiligne entre un port d'entrée/sortie 3, situé à une extrémité longitudinale du substrat 10 et un film réflecteur 4, par exemple un diélectrique multicouche, disposé sur une extrémité longitudinale opposée du substrat 10. Un deuxième guide d'onde 5 s'étend parallèlement au guide d'onde 2 à distance de celui-ci et un anneau résonateur 6 est disposé entre les deux guides d'onde 2 et 5 pour réaliser un couplage entre eux. L'anneau résonateur 6 est un guide d'onde fermé sur lui-même, par exemple de forme circulaire.

Plus précisément, une portion de l'anneau résonateur 6 est couplée avec une section intermédiaire 20 du guide d'onde 2 située entre une section d'amplification 21 s'étendant du côté du film réflecteur 4 et une section d'entrée/sortie 22 s'étendant du côté du port 3. Similairement une portion opposée de l'anneau résonateur 6 est couplée avec une section intermédiaire 50 du guide d'onde 5 située entre une section de réflexion 51 s'étendant du côté du film réflecteur 4 et une section de réception 52 s'étendant du côté du port 3.

La section de réception 52 aboutit à un photo-détecteur 8, par exemple une photodiode, permettant de détecter un signal optique entrant reçu depuis l'extérieur à travers le port 3. Les flèches 12 de la figure 1 représentent schématiquement le trajet de propagation suivi par un tel signal entrant, à savoir dans la section d'entrée/sortie 22, dans la section intermédiaire 20, dans l'anneau résonateur 6, dans la section intermédiaire 50 et dans la section de réception 52. Le passage dans l'anneau résonateur 6 provoque un filtrage spectral du fait des propriétés de résonance de l'anneau.

La section d'amplification 21 du guide d'onde 2 contient un matériau amplificateur de lumière 7, par exemple un matériau semi-conducteur dans lequel une inversion de population peut être produite par injection de courant, de manière à former un amplificateur optique à semi-conducteur ou SOA (pour l'anglais Semiconductor Optical Amplifier). Une cavité de Fabry-Pérot est ainsi formée entre les deux zones du film réflecteur 4 terminant respectivement le guide d'onde 2 et le guide d'onde 5, par l'intermédiaire de l'anneau résonateur 6, ce qui permet de produire un rayonnement laser du fait de l'amplification par le SOA d'un ou plusieurs modes résonants de la cavité.

Les flèches 13 de la figure 2 représentent schématiquement le trajet de propagation suivi par un tel rayonnement laser, à savoir dans la section d'amplification 21, dans la section intermédiaire 20, dans l'anneau résonateur 6, dans la section intermédiaire 50, dans la section de réflexion 51 et retour en sens inverse par réflexion sur le réflecteur 4. Le passage dans l'anneau résonateur 6 provoque un filtrage spectral du fait des propriétés de résonance de l'anneau. De plus, du fait que le couplage n'est pas parfait entre l'anneau résonateur 6 et le guide d'onde 2, une portion de la lumière ainsi amplifiée se propage à travers la section d'entrée/sortie 22 et le port 3, constituant ainsi un signal sortant 14.

Pour moduler le signal sortant 14, il peut être prévu un modulateur à électro-absorption 15 interposé dans la section d'entrée/sortie 22 ou une modulation directe du gain de la section d'amplification 21.

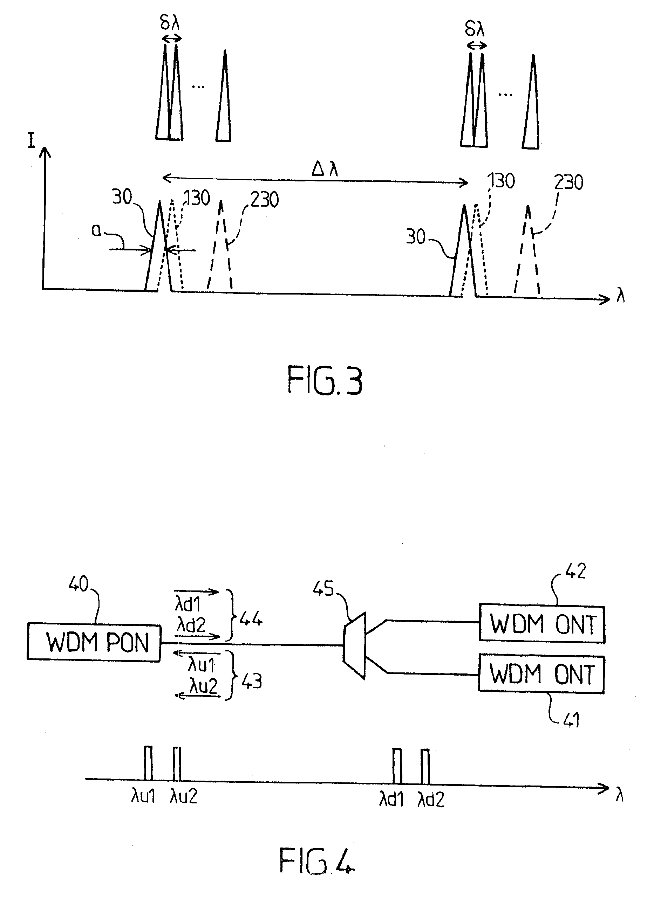

Le filtrage fréquentiel provoqué par l'anneau résonateur 6 à l'émission et à la réception présente une fonction de transfert périodique représentée schématiquement en trait continu sur la figure 3. Sur la figure 3, l'abscisse représente la longueur d'onde λ et l'ordonnée représente l'intensité I transmise par l'anneau résonateur 6. Cette fonction de transfert se présente sous la forme d'une succession de raies passantes 30 espacées de manière périodique d'un intervalle Δλ appelé intervalle spectral libre de l'anneau résonateur 6. Les raies 30 caractérisent les longueurs d'ondes porteuses sur lesquelles l'émetteur récepteur optique 1 pourrait recevoir ou émettre de la lumière. La largeur a des raies 30 et leur espacement mutuel Δλ peuvent être précisément dimensionnés par un dimensionnement correspondant de l'anneau résonateur 6. Qualitativement, l'intervalle spectral libre Δλ est inversement proportionnel à la taille de l'anneau.

Un intervalle spectral libre Δλ relativement élevé, par exemple de l'ordre de 30 nm ou plus peut être obtenu par un anneau 6 de petite taille. Les techniques de gravure sur substrat en Silicium sont relativement avantageuses cet égard. Un substrat InP peut aussi être envisagé.

De préférence, la cavité laser est conçue pour rayonner un mode longitudinal unique. Cette sélection de mode peut être opérée par le dimensionnement des éléments, à savoir notamment en satisfaisant les conditions suivantes :
- Intervalle spectral libre de la cavité laser inférieur à la largeur a d'une raie 30 de l'anneau résonateur 6.
- Largeur spectrale de la section d'amplification 21 inférieure à l'intervalle spectral libre Δλ de l'anneau résonateur 6.

Lorsque le laser rayonne comme indiqué ci-dessus, il est normal que le photo-détecteur 8 reçoive une intensité lumineuse substantielle à la longueur d'onde d'émission, du fait du couplage imparfait entre l'anneau résonateur 6 et le guide d'onde 5. Toutefois, du fait de la périodicité de la fonction de transfert de la figure 3, le photo-détecteur 8 est aussi capable de recevoir un signal entrant porté par une longueur d'onde différente de la longueur d'onde d'émission, plus grande ou plus petite, dont l'écart à la longueur d'onde d'émission est un multiple entier à l'intervalle spectral libre Δλ. Cette réception n'est toutefois pas possible si le photo-détecteur 8 est déjà saturé par le rayonnement laser émis.

Selon un mode de réalisation convenant notamment pour les réseaux à duplexage temporel, le photo-détecteur 8 est exploité dans une phase de réception dans laquelle le SOA est désactivé pour qu'aucun signal laser ne soit émis. Réciproquement, la section d'amplification 21 n'est exploitée que pendant une phase de transmission. Pendant la phase de transmission, le photo-détecteur 8 n'est pas exploité, ou alors seulement pour mesurer le niveau du signal transmis.

L'émetteur-récepteur optique 1 décrit ci-dessus peut être muni d'une fonction de réglage des longueurs d'onde. De retour à la figure 2, on a représenté schématiquement un film métallique chauffant 25 disposé sur l'anneau 6 et permettant de faire varier son indice de réfraction par effet thermo-optique. Par exemple, pour un anneau 6 présentant un intervalle spectral libre Δλ de 30nm, une variation d'indice à hauteur de 10⁻³ permet de déplacer les raies 30 d'environ 60GHz. Comme l'intervalle Δλ ne varie pas substantiellement au cours d'un tel réglage, toutes les raies 30 se décalent d'une même quantité de réglage δλ.

La figure 3 représente schématiquement une quantité de réglage δλ et, en trait pointillé, les raies 130 de la fonction de transfert obtenue après le réglage. Les raies 230 en trait interrompu représentent la fonction de transfert obtenue après un réglage plus grand. En général, la marge maximale de réglage des longueurs d'ondes est inférieure à l'intervalle spectral libre Δλ, mais ce n'est pas obligatoire.

La figure 2 représente schématiquement une unité de commande 26 de l'émetteur-récepteur optique 1. L'unité de commande 26 remplit différentes fonctions :
- commande du film chauffant 25 pour le réglage de longueur d'onde,
- commande de la section d'amplification 21 pour le réglage de gain ou l'activation,
- commande du modulateur 15 avec les données à transmettre,
- réception et traitement du signal détecté par le photo-détecteur 8.

L'émetteur récepteur optique 1 décrit ci-dessus permet de réaliser le réglage de la longueur d'onde émise de manière relativement simple, sous réserve que l'intervalle Δλ soit précisément caractérisé et que la marge d'erreur devant être compensée par le réglage soit plus petite que l'intervalle Δλ. Dans ce cas en effet, il suffit de contrôler précisément le réglage de la longueur d'onde reçue sur une raie, dont on sait qu'elle se trouve à exactement une distance égale à l'intervalle Δλ de la longueur d'onde d'émission.

Par exemple, une procédure possible pour accorder le laser sur une longueur d'onde donnée λ0 est :
- désactiver le laser,
- brancher sur le port 3 une source calibrée, dont la longueur d'onde est calibrée à λ0+Δλ, et
- régler la température de l'anneau 6 jusqu'à maximiser l'intensité détectée par le photo-détecteur 8,
- retirer la source calibrée et allumer le laser sans changer le réglage de température de l'anneau 6.

Comme illustré sur la figure 4, l'émetteur récepteur optique 1 décrit ci-dessus peut être exploité dans des équipements clients 41, 42 d'un réseau optique passif WDM, communiquant avec un poste central 40. De préférence, dans la phase de réception, l'émetteur récepteur optique 1 est exploité pour recevoir un signal dont la longueur d'onde λd est plus grande que la longueur d'onde émise λu. Ce choix résulte du fait que la meilleure zone de transmission des fibres optiques se situe dans le bas des plages de longueurs d'ondes envisagées pour les réseaux passifs WDM et qu'il est plus facile et moins coûteux de disposer des sources plus puissantes du côté du poste central 40 que du côté des équipements clients 41, 42.

Sur la figure 4, les deux équipements clients 41, 42 sont munis de deux émetteurs-récepteurs identiques conçus comme décrit ci-dessus, en particulier avec exactement le même l'intervalle spectral libre Δλ d'anneau. L'émetteur-récepteur de l'équipement client 41 est réglé pour recevoir une longueur d'onde prédéfinie λd1 transmise par le poste central 40 et pour émettre une longueur d'onde prédéfinie λu1=λd1-Δλ, à destination du poste central 40. De la même manière, l'émetteur-récepteur de l'équipement client 42 est réglé pour recevoir une longueur d'onde prédéfinie λd2 également transmise par le poste central 40 et différente de λd1 et pour émettre une longueur d'onde prédéfinie λu2=λd2-Δλ à destination du poste central 40. Le multiplexage des signaux montants 43 et la distribution des signaux descendants 44 peuvent être réalisés de manière très simple par un coupleur de puissance 45. En particulier, aucun filtre de longueur d'onde n'a besoin d'être implanté dans le réseau.

Le schéma de la figure 4 peut bien sûr être réalisé avec un nombre plus élevé d'équipements clients 42 ayant chacun deux longueurs d'onde dédiées distantes du même intervalle Δλ, par exemple pour un total de 16 ou 32 canaux. Une fois acquis le bon réglage des longueurs d'ondes descendantes, le réseau peut fonctionner de manière fiable sans risque de collision spectrale entre les longueurs d'ondes montantes.

Par exemple, les longueurs d'ondes porteuses du réseau passif peuvent se trouver dans une plage entre 1,53µm et 1,56µm.

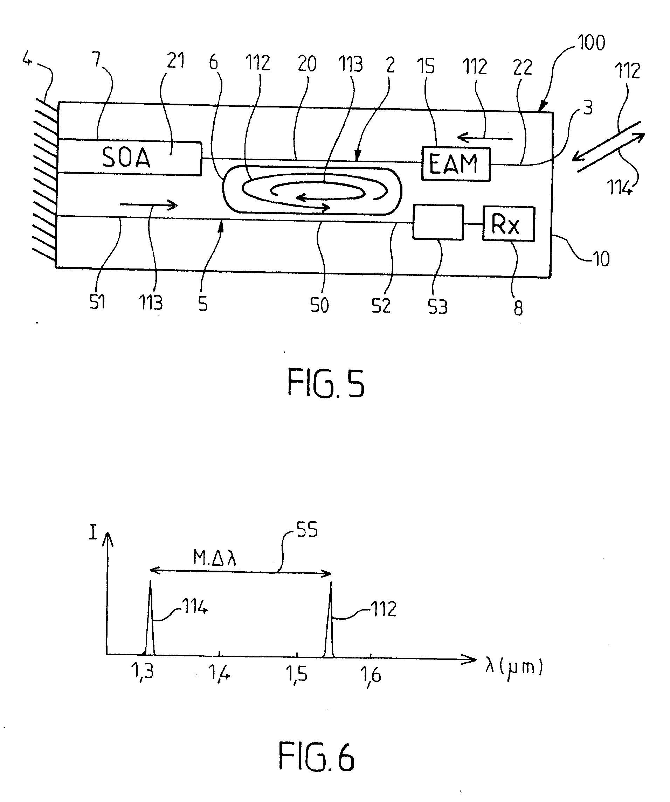

En référence à la figure 5, on va décrire un autre émetteur-récepteur optique 100 capable de fonctionner en émission et réception simultanée. Les éléments identiques à ceux de la figure 1 portent le même chiffre de référence que dans la figure 1 et ne sont pas décrits à nouveau.

Le mode de réalisation de la figure 5 se différencie en ce qu'il comporte un filtre spectral 53 agencé dans la section de réception 52 en amont du photo-détecteur 8. Le filtre 53 est choisi pour laisser passer le canal de longueur d'onde du signal entrant 112 et bloquer le canal de longueur d'onde du signal résonnant amplifié par la section d'amplification 7, à savoir le signal sortant 114. Ainsi, le dispositif peut émettre le signal laser 114 sans perturber la réception simultanée d'un signal entrant 112 par le photo-détecteur 8. De préférence, la longueur d'onde du signal sortant 114 est nettement inférieure à la longueur d'onde du signal entrant 112, et de préférence située autour de 1,3 µm pour bénéficier de la faible dispersion chromatique des fibres optiques à cette valeur. Le signal entrant est par exemple situé dans une plage comprise entre 1,5 et 1,6 µm, qui est aussi une fenêtre de transparence des fibres optiques. Pour cela, le filtre 53 peut être réalisé sous la forme d'un filtre passe-bande ou d'un filtre passe-bas, par exemple un filtre passe-bas obtenu en intégrant dans la section de réception 52 un matériau semi-conducteur polarisé négativement.

Comme montré sur la figure 6, du fait de l'anneau résonateur 6, l'écart entre la longueur d'onde du signal sortant 114 et la longueur d'onde du signal entrant 112 est égal à un multiple entier positif M de l'intervalle spectral libre Δλ.

Certains des éléments représentés, notamment les unités de commande, peuvent être réalisés sous différentes formes, de manière unitaire ou distribuée, au moyen de composants matériels et/ou logiciels. Des composants matériels utilisables sont les circuits intégrés spécifiques ASIC, les réseaux logiques programmables FPGA ou les microprocesseurs. Des composants logiciels peuvent être écrits dans différents langages de programmation, par exemple C, C++, Java ou VHDL. Cette liste n'est pas exhaustive.

Bien que l'invention ait été décrite en liaison avec plusieurs modes de réalisation particuliers, il est bien évident qu'elle n'y est nullement limitée et qu'elle comprend tous les équivalents techniques des moyens décrits ainsi que leurs combinaisons si celles-ci entrent dans le cadre de l'invention.

L'usage du verbe « comporter », « comprendre » ou « inclure » et de ses formes conjuguées n'exclut pas la présence d'autres éléments ou d'autres étapes que ceux énoncés dans une revendication. L'usage de l'article indéfini « un » ou « une » pour un élément ou une étape n'exclut pas, sauf mention contraire, la présence d'une pluralité de tels éléments ou étapes.

Dans les revendications, tout signe de référence entre parenthèses ne saurait être interprété comme une limitation de la revendication.

## Revendications

1. Emetteur-récepteur optique (1, 100) comportant :
un anneau résonateur (6),
un premier guide d'onde (2) comprenant successivement une section d'entrée-sortie, une section de couplage (20) couplée à une première portion de l'anneau résonateur et une section d'amplification (21) couplée à un premier réflecteur optique (4), le premier réflecteur optique étant apte à réfléchir de la lumière en direction de la section de couplage,
un deuxième guide d'onde (5) comportant successivement une section de réception, une section de couplage (50) couplée à une deuxième portion de l'anneau résonateur et une section de réflexion couplée à un deuxième réflecteur optique (4), le deuxième réflecteur optique étant apte à réfléchir de la lumière en direction de la section de couplage,
un milieu à gain (7) agencé dans la section d'amplification du premier guide d'onde et apte à produire une émission stimulée de lumière, et
un détecteur optique (8) couplé à la section de réception du deuxième guide d'onde.

2. Emetteur-récepteur optique selon la revendication 1, comportant en outre un mécanisme de réglage de la longueur d'onde (25) apte à modifier une propriété physique de l'anneau résonateur pour régler la ou les fréquences de résonance de l'anneau résonateur.

3. Emetteur-récepteur optique selon la revendication 2, dans lequel le mécanisme de réglage de la longueur d'onde (25) est apte à modifier la température de l'anneau résonateur pour changer l'indice de réfraction de l'anneau résonateur par effet thermooptique.

4. Emetteur-récepteur optique selon l'une des revendications 1 à 3, dans lequel une largeur spectrale du milieu à gain (7) est inférieure à l'intervalle spectral libre de l'anneau résonateur (6).

5. Emetteur-récepteur optique selon l'une des revendications 1 à 4, comportant en outre un substrat (10) sur lequel l'anneau résonateur, le premier guide d'onde et le deuxième guide d'onde sont intégrés de manière monolithique.

6. Emetteur-récepteur optique selon la revendication 5, dans lequel le substrat est en Silicium.

7. Emetteur-récepteur optique selon la revendication 5 ou 6, comportant en outre un film réfléchissant (4) déposé sur une surface d'extrémité du substrat et formant les premier et deuxième réflecteurs optiques.

8. Emetteur-récepteur optique selon l'une des revendications 1 à 7, comportant en outre un modulateur optique (15) couplé au premier guide d'onde pour moduler un signal optique généré par le milieu à gain.

9. Emetteur-récepteur optique selon l'une des revendications 1 à 8, comportant en outre une unité de commande (26) apte à piloter le gain du milieu à gain et/ou d'autres éléments de l'émetteur-récepteur optique.

10. Emetteur-récepteur optique (100) selon l'une des revendications 1 à 9, comportant en outre un filtre spectral (53) agencé dans la section de réception (52) en amont du détecteur optique (8) pour laisser passer un signal optique (112) à recevoir par le détecteur optique (8) et bloquer un signal optique (114) à émettre par l'émetteur-récepteur (100).

11. Emetteur-récepteur optique selon la revendication 10, dans lequel le filtre spectral (53) est un filtre passe-bas, la longueur d'onde du signal à recevoir (112) étant plus grande que la longueur d'onde du signal à émettre (114).

12. Procédé d'exploitation d'un émetteur-récepteur optique selon l'une des revendications 1 à 11, dans lequel
dans un mode de fonctionnement émetteur dans lequel le milieu à gain (7) est activé, l'émetteur récepteur optique transmet vers l'extérieur à travers la section d'entrée-sortie un signal optique monochromatique ayant une première longueur d'onde porteuse (λu1), et
dans un mode de fonctionnement récepteur dans lequel le milieu à gain (7) est désactivé, l'émetteur récepteur optique reçoit depuis l'extérieur à travers la section d'entrée-sortie un signal optique comportant une composante monochromatique ayant une deuxième longueur d'onde porteuse (λd1), l'écart entre la première longueur d'onde porteuse et la deuxième longueur d'onde porteuse étant égal à l'intervalle spectral libre (Δλ) de l'anneau résonateur ou un multiple entier de celui-ci.

13. Procédé d'exploitation selon la revendication 12, dans lequel la section d'entrée-sortie (22) de l'émetteur-récepteur optique est reliée par un réseau optique à un noeud de communication (40),
dans lequel le signal optique monochromatique ayant la première longueur d'onde porteuse est modulé avec un flux de données montant et transporte le flux de données montant depuis l'émetteur-récepteur optique (1, 41) jusqu'au noeud de communication (40), et
dans lequel la composante monochromatique ayant la deuxième longueur d'onde porteuse est modulée avec un flux de données descendant et transporte le flux de données descendant depuis le noeud de communication (40) jusqu'à l'émetteur-récepteur optique (1, 41).

14. Procédé d'exploitation selon la revendication 12 ou 13, dans lequel le mode de fonctionnement émetteur et le mode de fonctionnement récepteur sont exploités alternativement selon un schéma périodique de duplexage temporel.

15. Procédé d'exploitation selon la revendication 12 ou 13, dans lequel le mode de fonctionnement émetteur et le mode de fonctionnement récepteur sont exploités simultanément selon un schéma de duplexage spectral.

## Patentansprüche

1. Optischer Sender-Empfänger (1, 100), umfassend:
einen Resonanzring (6),
einen ersten Wellenleiter (2), umfassend aufeinanderfolgend einen Eingang-Ausgang-Abschnitt, einen Koppelabschnitt (20), welcher an einen ersten Teil des Resonanzrings gekoppelt ist, und einen Verstärkungsabschnitt (21), welcher an einen ersten optischen Reflektor (4) gekoppelt ist, wobei der erste optische Reflektor dazu geeignet ist, Licht in Richtung des Koppelabschnitts zu reflektieren,
einen zweiten Wellenleiter (5), umfassend aufeinanderfolgend einen Empfangsabschnitt, einen Koppelabschnitt (50), welcher an einen zweiten Teil des Resonanzrings gekoppelt ist, und einen Reflexionsabschnitt, welcher an einen zweiten optischen Reflektor (4) gekoppelt ist, wobei der zweite optische Reflektor dazu geeignet ist, Licht in Richtung des Koppelabschnitts zu reflektieren,
ein Verstärkungsmedium (7), welches in dem Verstärkungsabschnitt des ersten Wellenleiters angeordnet und dazu geeignet ist, eine stimulierte Lichtemission zu erzeugen, und
einen optischen Sensor (8), welcher an den Empfangsabschnitt des zweiten Wellenleiters gekoppelt ist.

2. Optischer Sender-Empfänger gemäß Anspruch 1, weiterhin umfassend einen Wellenlängen-Einstellmechanismus (25), welcher dazu geeignet ist, eine physikalische Eigenschaft des Resonanzrings zu modifizieren, um die Resonanzfrequenz(en) des Resonanzrings einzustellen.

3. Optischer Sender-Empfänger gemäß Anspruch 2, wobei der Wellenlängen-Einstellmechanismus (25) dazu geeignet ist, die Temperatur des Resonanzrings zu modifizieren, um den Brechungsindex des Resonanzrings durch thermo-optischen Effekt zu ändern.

4. Optischer Sender-Empfänger gemäß einem der Ansprüche 1 bis 3, wobei eine Spektralbreite des Verstärkungsmediums (7) kleiner als das freie Spektralintervall des Resonanzrings (6) ist.

5. Optischer Sender-Empfänger gemäß einem der Ansprüche 1 bis 4, weiterhin umfassend ein Substrat (10), auf dem der Resonanzring, der erste Wellenleiter und der zweite Wellenleiter monolithisch integriert sind.

6. Optischer Sender-Empfänger gemäß Anspruch 5, wobei das Substrat aus Silicium ist.

7. Optischer Sender-Empfänger gemäß Anspruch 5 oder 6, weiterhin umfassend eine reflektierende Schicht (4), welche auf einer Endoberfläche des Substrats aufgetragen ist und den ersten und den zweiten optischen Reflektor bildet.

8. Optischer Sender-Empfänger gemäß einem der Ansprüche 1 bis 7, weiterhin umfassend einen optischen Modulator (15), welcher an den ersten Wellenleiter gekoppelt ist, um ein von dem Verstärkungsmedium erzeugtes optisches Signal zu modulieren.

9. Optischer Sender-Empfänger gemäß einem der Ansprüche 1 bis 8, weiterhin umfassend eine Bedienungseinheit (26), welche dazu geeignet ist, die Verstärkung des Verstärkungsmediums und/oder andere Elemente des optischen Sender-Empfängers zu steuern.

10. Optischer Sender-Empfänger (100) gemäß einem der Ansprüche 1 bis 9, weiterhin umfassend einen Spektralfilter (53), welcher in dem Empfangsabschnitt (52) dem optischen Sensor (8) vorgelagert angeordnet ist, um ein von dem optischen Sensor (8) zu empfangendes optisches Signal (112) durchzulassen und ein von dem Sender-Empfänger (100) zu emittierendes optisches Signal (114) zu blockieren.

11. Optischer Sender-Empfänger gemäß Anspruch 10, wobei der Spektralfilter (53) ein Tiefpassfilter ist, wobei die Wellenlänge des zu empfangenden Signals (112) größer als die Wellenlänge des zu emittierenden Signals (114) ist.

12. Verfahren zum Betreiben eines optischen Sender-Empfängers gemäß einem der Ansprüche 1 bis 11, wobei
in einer Emissionsbetriebsart, in der das Verstärkungsmedium (7) aktiviert ist, der optische Sender-Empfänger über den Eingang-Ausgang-Abschnitt ein monochromatisches optisches Signal nach außen überträgt, welches eine erste Trägerwellenlänge (λu1) aufweist, und
in einer Empfangsbetriebsart, in der das Verstärkungsmedium (7) deaktiviert ist, der optische Sender-Empfänger über den Eingang-Ausgang-Abschnitt ein optisches Signal mit einer monochromatischen Komponente von außen empfängt, welche eine zweite Trägerwellenlänge (λd1) aufweist, wobei der Abstand zwischen der ersten Trägerwellenlänge und der zweiten Trägerwellenlänge dem freien Spektralintervall (Δλ) des Resonanzrings oder einem ganzzahligen Vielfachen desselben gleich ist.

13. Verfahren zum Betreiben gemäß Anspruch 12, wobei der Eingang-Ausgang-Abschnitt (22) des optischen Sender-Empfängers über ein optisches Netzwerk mit einem Kommunikationsknoten (40) verbunden ist,
wobei das optische monochromatische Signal aufweisend die erste Trägerwellenlänge mit einem Aufwärtsdatenstrom moduliert wird und den Aufwärtsdatenstrom von dem optischen Sender-Empfänger (1,41) bis zu dem Kommunikationsknoten (40) transportiert, und wobei die monochromatische Komponente aufweisend die zweite Trägerwellenlänge mit einem Abwärtsdatenstrom moduliert wird und den Abwärtsdatenstrom von dem Kommunikationsknoten (40) bis zu dem optischen Sender-Empfänger (1, 41) transportiert.

14. Verfahren zum Betreiben gemäß Anspruch 12 oder 13, wobei die Emissionsbetriebsart und die Empfangsbetriebsart abwechselnd in einem periodischen Zeitduplex-Muster betrieben werden.

15. Verfahren zum Betreiben gemäß Anspruch 12 oder 13, wobei die Emissionsbetriebsart und die Empfangsbetriebsart gleichzeitig in einem Spektralduplex-Muster betrieben werden.

## Claims

1. An optical transceiver (1, 100) comprising:
a ring resonator (6),
a first waveguide (2) comprising, in succession, an input-output section, a coupling section (20) coupled to a first portion of the ring resonator and an amplification section (21) coupled to a first optical reflector (4), the first optical reflector being suitable for reflecting light toward the coupling section,
a second waveguide (5) comprising, in succession, a reception section, a coupling section (50) coupled to a second portion of the ring resonator and a reflection section coupled to a second optical reflector (4), the second optical reflector being suitable for reflecting light toward the coupling section,
a gain medium (7) arranged in the amplification section of the first waveguide and suitable for producing a stimulated light transmission, and
an optical detector (8) coupled to the reception section of the second waveguide.

2. The optical transceiver as claimed in claim 1, also comprising a wavelength setting mechanism (25) suitable for modifying a physical property of the ring resonator to set the resonance frequency or frequencies of the ring resonator.

3. The optical transceiver as claimed in claim 2, in which the wavelength setting mechanism (25) is suitable for modifying the temperature of the ring resonator to change the refractive index of the ring resonator by thermo-optical effect.

4. The optical transceiver as claimed in one of claims 1 to 3, in which a spectral width of the gain medium (7) is less than the free spectral interval of the ring resonator (6).

5. The optical transceiver as claimed in one of claims 1 to 4, also comprising a substrate (10) on which the ring resonator, the first waveguide and the second waveguide are integrated in a monolithic manner.

6. The optical transceiver as claimed in claim 5, in which the substrate is made of silicon.

7. The optical transceiver as claimed in claim 5 or 6, also comprising a reflecting film (4) deposited on an end surface of the substrate and forming the first and second optical reflectors.

8. The optical transceiver as claimed in one of claims 1 to 7, also comprising an optical modulator (15) coupled to the first waveguide to modulate an optical signal generated by the gain medium.

9. The optical transceiver as claimed in one of claims 1 to 8, also comprising a control unit (26) suitable for controlling the gain of the gain medium and/or of other elements of the optical transceiver.

10. The optical transceiver (100) as claimed in one of claims 1 to 9, also comprising a spectral filter (53) arranged in the reception section (52) upstream of the optical detector (8) to allow the passage of an optical signal (112) to be received by the optical detector (8) and to block an optical signal (114) to be transmitted by the transceiver (100).

11. The optical transceiver as claimed in claim 10, in which the spectral filter (53) is a low-pass filter, the wavelength of the signal to be received (112) being greater than the wavelength of the signal to be transmitted (114).

12. A method for operating an optical transceiver as claimed in one of claims 1 to 11, in which
in a transmitter operating mode in which the gain medium (7) is activated, the optical transceiver transmits outward, through the input-output section, a monochromatic optical signal having a first carrier wavelength (λu1), and
in a receiver operating mode in which the gain medium (7) is deactivated, the optical transceiver receives, from the outside, through the input-output section, an optical signal comprising a monochromatic component having a second carrier wavelength (λd1), the difference between the first carrier wavelength and the second carrier wavelength being equal to the free spectral interval (Δλ) of the ring resonator or an integer multiple thereof.

13. The operating method as claimed in claim 12, in which the input-output section (22) of the optical transceiver is linked by an optical network to a communication node (40),
in which the monochromatic optical signal having the first carrier wavelength is modulated with an uplink data stream and transports the uplink data stream from the optical transceiver (1, 41) to the communication node (40), and
in which the monochromatic component having the second carrier waveiength is modulated with a downlink data stream and transports the downlink data stream from the communication node (40) to the optical transceiver (1, 41).

14. The operating method as claimed in claim 12 or 13, in which the transmitter operating mode and the receiver operating mode are used alternately according to a periodic time-division duplexing scheme.

15. The operating method as claimed in claim 12 or 13, in which the transmitter operating mode and the receiver operating mode are used simultaneously according to a spectral duplexing scheme.
